# FASCICULE DE BREVET EUROPEEN

(11) **EP 3 175 249 B1**
(45) Date de publication et mention de la délivrance du brevet: **08.04.2020**
(21) Numéro de dépôt: 15742271.8
(22) Date de dépôt: 27.07.2015
(51) Int. Cl.: G01R 31/12

(54) **DISPOSITIF DE DETECTION DE DECHARGE PARTIELLE DE MATERIEL HAUTE TENSION ISOLE AU GAZ**
VORRICHTUNG ZUR ERKENNUNG EINER PARTIELLEN ENTLADUNG AUS EINER HOCHDRUCKGASISOLIERTEN AUSRÜSTUNG
DEVICE FOR DETECTING A PARTIAL DISCHARGE FROM HIGH-VOLTAGE GAS-INSULATED EQUIPMENT

(30) Priorité: 28.07.2014 FR 1457296
(43) Date de publication de la demande: 07.06.2017
(73) Titulaire: General Electric Technology GmbH, 5400 Baden (CH)
(72) Inventeur: VUACHET, Jacques, F-74330 Poisy (FR); MAUFFREY, Thibaut, F-74000 Annecy (FR)
(74) Mandataire: Brevalex
(86) Numéro de dépôt international: PCT/EP2015/067177
(87) Numéro de publication internationale: WO 2016/016198

(56) Documents cités:
- EP-A1- 2 685 268
- CN-A- 101 557 035
- CN-A- 102 520 322
- CN-A- 102 608 506
- CN-A- 102 916 247
- CN-U- 202 421 426
- CN-U- 202 661 586
- JUDD M D ED - INSTITUTE OF ELECTRICAL AND ELECTRONICS ENGINEERS: "DIELECTRIC WINDOWS IMPROVE SENSITIVITY OF PARTIAL DISCHARGE DETECTION AT UHF", CONFERENCE RECORD OF THE 2000 IEEE INTERNATIONAL SYMPOSIUM ON ELECTRICAL INSULATION. (ISEI 2000). ANAHEIM, CA, APRIL 2-5, 2000; [INTERNATIONAL SYMPOSIUM ON ELECTRICAL INSULATION], NEW YORK, NY : IEEE, US, 2 avril 2000 (2000-04-02), pages 304-307, XP000977236, ISBN: 978-0-7803-5932-1

## Description

### DOMAINE TECHNIQUE ET ART ANTERIEUR

L'invention concerne un dispositif de détection de décharge partielle de matériel haute tension isolé au gaz ainsi qu'un poste électrique haute tension isolé au gaz équipé d'un dispositif de détection de décharge partielle de l'invention.

A ce jour, les dispositifs de détection de décharge partielle des matériels haute tension isolés au gaz (GIS en langue anglaise pour « Gaz Insulated Systems ») utilisent des antennes monopolaires ou des antennes dipolaires qui sont placées soit à l'intérieur, soit à l'extérieur des matériels. Ces dispositifs sont connus des documents CN 102 520 322 A, CN 202 421 426 U et EP 2 685 268 A1.

Placées à l'intérieur, les antennes sont fixées sur les cuves des matériels haute tension. Placées à l'extérieur, les antennes sont fixées sur les hublots qui permettent le contrôle visuel des sectionneurs (couplage/découplage) ou sur la face externe des pièces électriquement isolantes qui maintiennent la barre haute tension du matériel.

Placées à l'intérieur des matériels, les antennes monopolaires ou dipolaires ont généralement une sensibilité suffisante pour détecter les décharges partielles qui surviennent dans le matériel. A titre d'exemple, la demande de brevet français déposée auprès de l'Institut National de la Propriété Industrielle sous le numéro d'enregistrement national 09 54160 et intitulée « Dispositif de surveillance d'un poste électrique haute tension isolé au gaz par mesure de décharges partielles et poste électrique haute tension isolé au gaz mettant en œuvre ce dispositif » divulgue une antenne conique monopôle utilisée pour la réalisation d'un capteur de champ électrique à large bande de fréquence (typiquement 100MHz - 2 GHz).

Placées à l'extérieur des matériels, la sensibilité des antennes monopolaires ou dipolaires est souvent insuffisante du fait de leur plus grand éloignement des sources de décharge partielle éventuelles. La recommandation de sensibilité TGN21 intitulée « *Capacitive couplers for UHF partial discharge monitoring* » spécifiée dans la note technique *« Technical Guidance Note TGN(T) 121 »* de la National Grid Company plc ne peut alors plus être assurée dans de bonnes conditions.

Ceci est un réel inconvénient. Dans le cas où, par exemple, il n'est plus possible de placer d'antennes à l'intérieur d'un matériel existant et que seules des antennes extérieures peuvent être installées, le dispositif de détection de décharge partielle est alors peu performant.

L'invention ne présente pas les inconvénients mentionnés ci-dessus. L'invention est définie par les revendications indépendantes 1 et 7 et leurs revendications dépendantes correspondantes.

### EXPOSE DE L'INVENTION

En effet, l'invention concerne un dispositif de détection de décharge partielle de matériel haute tension isolé au gaz, le dispositif comprenant au moins une antenne placée à l'extérieur du matériel haute tension isolé au gaz, en vis-à-vis d'un hublot du matériel haute tension isolé au gaz, caractérisé en ce qu'il comprend, en outre, une bride métallique qui est mise en contact électrique avec une paroi métallique du matériel haute tension et contribue à former, en combinaison avec la dite paroi, une cage de Faraday qui isole électriquement l'antenne de l'extérieur du matériel haute tension, la bride métallique ayant une paroi concave qui fait face au hublot.

La concavité de la bride métallique induit une variation de hauteur entre la bride métallique et l'antenne. Cette variation de hauteur permet avantageusement d'optimiser l'enceinte de réflexion que constitue la cage de Faraday. Les phénomènes de résonance susceptibles de survenir dans le spectre de détection peuvent alors être évités et il est possible d'homogénéiser la sensibilité de détection sur tout le spectre utile.

Dans cette variante de l'invention, les antennes peuvent être de tout type, à savoir monopolaire, dipolaire, à spirale, fractale, etc..

Afin de contribuer à l'évitement de l'apparition des phénomènes de résonance et à l'homogénéisation de la sensibilité de détection mentionnés ci-dessus, l'invention prévoit également, dans des modes de réalisation particuliers, que l'antenne présente, en regard de la paroi concave de la bride, une surface concave ou une surface convexe.

L'invention concerne également un dispositif de détection de décharge partielle de matériel haute tension isolé au gaz, le dispositif comprenant une antenne à architecture fractale placée à l'extérieur dudit matériel, caractérisé en ce que l'antenne à architecture fractale est située en vis-à-vis d'une face externe d'une pièce électriquement isolante qui assure le maintien d'une barre haute tension à l'intérieur du matériel haute tension, et dans lequel, en outre, une structure métallique qui entoure l'antenne contribue à former une cage de Faraday qui isole électriquement l'antenne de l'extérieur du matériel haute tension isolé au gaz, dans lequel la cage de Faraday forme une enceinte de réflexion qui présente une paroi concave située face à la pièce électriquement isolante.

Comme cela est connu de l'homme de l'art, une antenne à architecture fractale est constituée de plusieurs antennes de petites dimensions composées à partir de motifs identiques.

L'antenne à architecture fractale est avantageusement de petites dimensions. Un dispositif de détection de décharge partielle de l'invention a en conséquence un très faible encombrement. Il est alors avantageusement possible de réaliser des dispositifs de détection de décharge partielle dans des espaces restreints et confinés.

Lorsque l'antenne est placée à l'extérieur du matériel haute tension, l'antenne à architecture fractale garantit d'excellentes performances de détection du fait de sa grande sensibilité.

L'invention concerne aussi un poste électrique haute tension isolé au gaz équipé d'un dispositif de détection de décharge partielle, caractérisé en ce que le dispositif de détection de décharge partielle est un dispositif selon l'invention.

### BREVE DESCRIPTION DES FIGURES

D'autres caractéristiques et avantages de l'invention apparaîtront à la lecture de modes de réalisation préférentiels faits en référence aux figures jointes, parmi lesquelles :
- la figure 1 représente un premier mode de réalisation du dispositif de détection de décharge partielle selon l'invention ;
- la figure 2 représente un perfectionnement du premier mode de réalisation de dispositif de détection de décharge partielle de l'invention ;
- les figure 3A et 3B représentent deux variantes d'un deuxième mode de réalisation du dispositif de détection de décharge partielle selon l'invention ;
- les figures 4A et 4B représentent deux variantes d'un troisième mode de réalisation du dispositif de détection de décharge partielle selon l'invention ;
- la figure 5 représente une généralisation du perfectionnement représenté en figure 2 à tout type d'antenne ;
- la figure 6 représente une première variante de dispositif de détection apte à optimiser le perfectionnement représenté en figure 5 ;
- la figure 7 représente une deuxième variante de dispositif de détection apte à optimiser le perfectionnement représenté en figure 5 ;
- la figure 8 représente une troisième variante de dispositif de détection apte à optimiser le perfectionnement représenté en figure 5 ;
- la figure 9 représente un dispositif de détection de décharge partielle de l'invention muni d'une première variante de moyens élastiques de maintien de l'antenne qui participe au dispositif de détection;
- la figure 10 représente un dispositif de détection de décharge partielle de l'invention muni d'une deuxième variante de moyens élastiques de maintien de l'antenne qui participe au dispositif de détection;
- les figures 11A-11B représentent un dispositif de détection de décharge partielle de l'invention muni d'une troisième variante de moyens élastiques de maintien de l'antenne qui participe au dispositif de détection.

Sur toutes les figures, les mêmes références désignent les mêmes éléments.

### EXPOSÉ DÉTAILLÉ DE MODES DE RÉALISATION PARTICULIERS

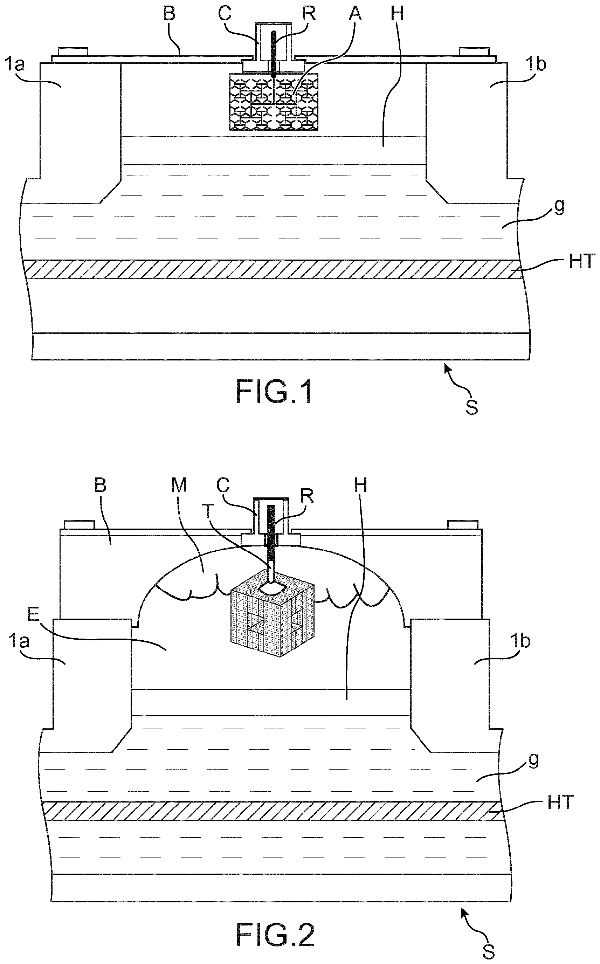

La figure 1 représente un premier mode de réalisation du dispositif de détection de décharge partielle selon l'invention.

Selon le premier mode de réalisation, le dispositif de détection de décharge partielle est monté sur un hublot de contrôle visuel.

Le matériel haute tension isolé au gaz S comprend une barre haute tension HT placée dans un gaz g. Un hublot H est monté dans une pièce de maintien la, 1b. Le dispositif de détection de décharge partielle comprend une antenne à architecture fractale A placée en regard du hublot H. L'antenne A est électriquement reliée, par exemple par soudure ou par brochage, à l'extrémité de l'âme R d'un connecteur coaxial C. L'antenne A est par ailleurs fixée, par exemple à l'aide de colle, à la base du connecteur C. Une bride B maintient le connecteur C et l'antenne A au-dessus du hublot H. L'antenne A est préférentiellement positionnée au plus près du hublot H, par exemple à une distance égale à 2mm.

L'élément de maintien la, 1b et la bride B sont électriquement conducteurs et constituent, avec le corps électriquement conducteur du matériel haute tension isolé au gaz, une cage de Faraday qui isole l'antenne A des perturbations électromagnétiques susceptibles de provenir de l'extérieur du matériel haute tension.

L'antenne à architecture fractale A est une antenne 2D (i.e. à deux dimensions) ou une antenne 3D (i.e. à trois dimensions) qui travaille dans tout ou partie d'une bande de fréquences typiquement comprises entre 100MHz et 3000MHz. De façon préférentielle, pour couvrir la totalité de la bande de fréquences, l'antenne A est constituée d'une pluralité d'antennes élémentaires couvrant chacune une partie de la bande comprise entre 100MHz et 3000MHz.

L'antenne A peut être constituée d'une ou plusieurs antennes à architecture fractale du commerce. L'antenne A peut également être une antenne à architecture fractale ou une association d'antennes à architecture fractale conçues spécifiquement par tout moyen connu en soi. Ainsi, l'antenne A peut-elle être une antenne à architecture fractale 2D formée sur circuit imprimé ou par impression d'encre conductrice sur un substrat souple. L'antenne A peut également être une antenne à architecture fractale 3D formée à l'aide de procédés multi-couches ou à l'aide d'une imprimante 3D dans une matrice de matériau électriquement isolant.

Une antenne à architecture fractale a de très faibles dimensions. A titre d'exemple non limitatif, une antenne 3D peut avoir la forme d'un cube ayant une arête de 5mm de long. Un avantage du dispositif de détection de décharge partielle de l'invention est alors d'avoir un très faible encombrement.

La figure 2 représente un perfectionnement du dispositif de détection de décharge partielle représenté en figure 1.

Selon le perfectionnement représenté en figure 2, la cage de Faraday constitue une chambre de réflexion E qui optimise la détection des ondes par l'antenne A.

La forme de la chambre de réflexion et la position de l'antenne dans la chambre de réflexion sont alors calculées pour optimiser la réflexion des ondes en direction de l'antenne A. Dans cette configuration, une transition électrique T, par exemple un fil électriquement conducteur ou un élément électriquement conducteur de géométrie fractale, relie l'extrémité de l'âme R du connecteur C à l'antenne. Une première extrémité de la transition électrique T est alors reliée, par exemple par soudure ou par brochage, à l'extrémité de l'âme R, et la deuxième extrémité de la transition T est reliée, par exemple par soudure, à l'antenne A. La longueur de la transition électrique T est avantageusement choisie pour placer l'antenne dans une position optimale.

De façon préférentielle, l'ensemble constitué de l'antenne A et de la transition électrique T est fixé à la bride B à l'aide d'une mousse M. D'autres types de fixation sont toutefois possibles.

Dans le cas d'une fixation par mousse, la mousse a une constante diélectrique relative proche de 1 et est déposée, par exemple, par pulvérisation sur la bride B. La mousse M est, par exemple, un éthylène-propylène-diène monomère également connu sous l'appellation EPDM. La mousse M peut être présente dans tout le volume compris entre la bride B et le hublot H. Elle peut également n'être présente sur la bride qu'au niveau où s'effectue la fixation de l'antenne, comme cela est repésenté en figure 2. Dans tous les cas, la mousse M permet avantageusement une fixation de l'antenne robuste aux chocs et aux virations. Dans le cas où la mousse M est présente dans la totalité du volume entre bride et hublot, la mousse M permet avantageusement de supprimer toute zone de pollution éventuelle (humidité, particules, etc.).

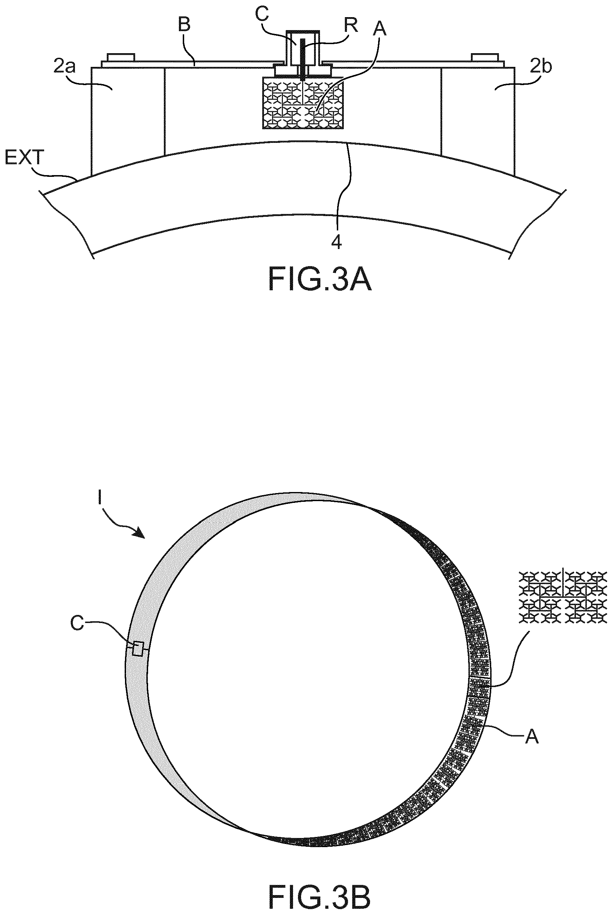

Les figures 3A et 3B représentent deux variantes d'un deuxième mode de réalisation du dispositif de détection de décharge partielle selon l'invention.

Selon le deuxième mode de réalisation, l'antenne A est placée sur la face externe d'une pièce électriquement isolante de maintien de la barre haute tension.

La figure 3A représente une première variante du deuxième mode de réalisation de l'invention selon laquelle l'antenne est placée dans un volume constitué d'une fraction de surface 4 de la face externe EXT de la pièce électriquement isolante, d'une pièce métallique creuse de forme cylindrique 2a, 2b fixée sur la face externe EXT et d'une bride B qui ferme la pièce métallique creuse à l'opposé de la fraction de surface 4 et qui maintient l'antenne A et le connecteur C relié à l'antenne au dessus de la fraction de surface 4. De même que précédemment, l'antenne A est reliée à l'âme R du connecteur C et l'antenne est fixée, par exemple à l'aide de colle, à la base du connecteur C.

La pièce métallique creuse 2a, 2b et la bride B constituent, avec le corps métallique du matériel haute tension situé à proximité de la face externe de la pièce électriquement isolante, une cage de Faraday qui isole l'antenne A des perturbations électromagnétiques susceptibles de provenir de l'extérieur du matériel haute tension. Dans un mode de réalisation particulier, le volume dans lequel l'antenne A est placée constitue une chambre de réflexion qui optimise la détection des ondes par l'antenne. Comme mentionné précédemment, de façon préférentielle, l'antenne A est alors reliée à l'âme R du connecteur C par une transition électrique T et l'antenne A et la transition électrique T sont fixés à la bride B à l'aide d'une mousse M.

La figure 3B représente une deuxième variante du deuxième mode de réalisation de l'invention, selon laquelle l'antenne à architecture fractale A est formée sur la face interne d'une bande de circuit imprimé I dont la face externe est une piste électriquement conductrice pleine. La face interne de la bande de circuit imprimé est alors fixée sur la face externe EXT de la pièce électriquement isolante et la face externe de la bande de circuit imprimé est tournée vers l'extérieur du matériel haute tension. La face externe de la bande de circuit imprimé constitue, avec le corps métallique du matériel haute tension, une cage de Faraday qui isole l'antenne des perturbations extérieures. Un connecteur C établit la liaison électrique entre l'antenne A et l'extérieur du dispositif. La bande de circuit imprimé I est de faible épaisseur, par exemple 0,5mm, afin de rester souple et pouvoir ainsi envelopper l'extérieur de la pièce électriquement isolante.

De façon avantageuse, la Demanderesse a constaté qu'un éloignement de la piste électriquement conductrice pleine de la face externe EXT améliore très sensiblement la sensibilité de détection. Il est ainsi possible, par exemple, d'améliorer la sensibilité de détection d'un facteur 3. L'antenne à architecture fractale est alors réalisée par une métallisation de géométrie fractale déposée sur la face interne d'une bande de mousse alvéolée de plusieurs millimètres d'épaisseur (par exemple 5mm) dont la face externe est recouverte d'une métallisation uniforme (par exemple de l'aluminium). La mousse alvéolée est, par exemple, un éthylène-propylène-diène monomère.

Concernant cet éloignement de la piste électriquement conductrice pleine de la face externe EXT, il faut également noter que la Demanderesse en a constaté l'avantage quel que soit le type de motif de l'antenne (motif de géométrie fractale ou non).

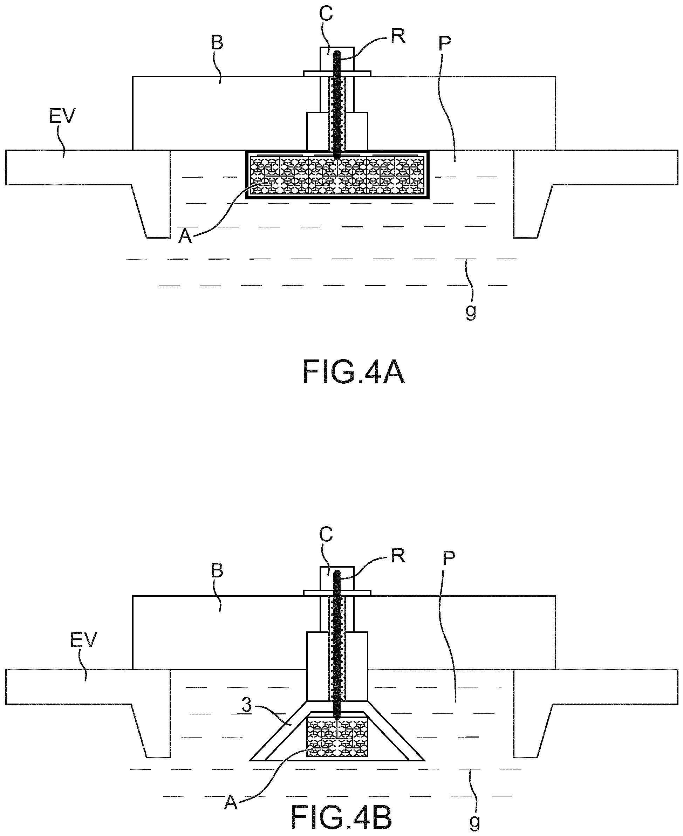

Les figures 4A et 4B représentent deux variantes d'un troisième mode de réalisation de l'invention. Selon le troisième mode de réalisation de l'invention, l'antenne à architecture fractale est placée à l'intérieur du matériel haute tension, dans une partie creuse P du matériel haute tension, formée dans l'enveloppe métallique EV dudit matériel.

Une bride B fixée à l'enveloppe métallique EV ferme la partie creuse P dans laquelle l'antenne est placée. Le connecteur C relié à l'antenne A est fixé dans la bride B. La bride B constitue, avec le corps du matériel haute tension, une cage de Faraday qui isole électriquement l'antenne A des perturbations électromagnétiques susceptibles de provenir de l'extérieur du matériel. L'antenne A est placée dans le gaz g.

Dans une première variante du troisième mode de réalisation de l'invention, l'antenne A est collée à la bride B, dans une zone à faible concentration de champ électrique (puits de potentiel). Aucune protection électrique particulière de l'antenne n'est prévue dans cette variante du fait de la faible concentration du champ qui entoure l'antenne (cf. figure 4A).

Dans la deuxième variante du troisième mode de réalisation de l'invention, l'antenne A est éloignée de la bride B, dans une zone susceptible d'être à forte activité électromagnétique. Un élément de protection 3 en matériau électriquement conducteur est alors fixé au connecteur C et entoure l'antenne A. L'élément de protection 3 a pour fonction de prévenir tout phénomène de concentration de champ électrique au niveau de l'antenne (effet de pointe). Le support 3 est préférentiellement de forme conique, la partie du cône la plus étroite étant fixée au connecteur C et la partie du cône la plus évasée étant la plus éloignée du connecteur C.

Comme cela a été mentionné précédemment, l'antenne A est une antenne 2D ou 3D pouvant être constituée d'une ou plusieurs antennes couvrant tout ou partie de la bande de fréquences 100MHz - 2000MHz.

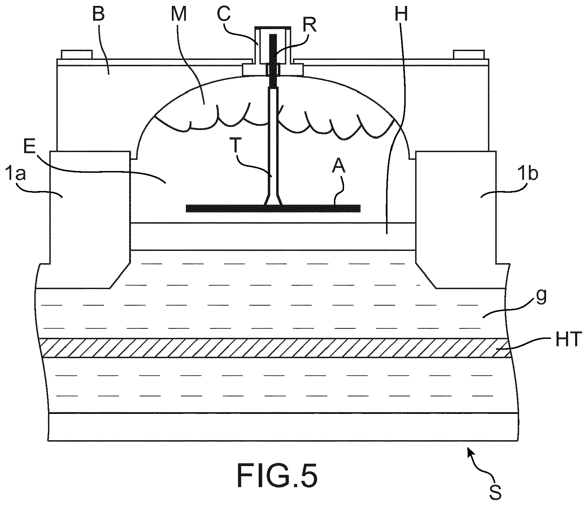

La figure 5 représente une généralisation du perfectionnement représenté en figure 2.

En effet, la figure 5 représente un dispositif de détection placé sur hublot, dans lequel l'antenne A peut être une antenne monopolaire, ou une antenne dipolaire, ou une antenne fractale, ou une antenne à spirale, etc., l'antenne, quelle qu'elle soit, pouvant être 2D ou 3D.

La cage de Faraday constituée par l'élément de maintien la, 1b, la bride B et le corps métallique du matérial haute tension constitue une chambre de réflexion E qui optimise la détection des ondes par l'antenne A, quelle que soit cette antenne. La bride B présente une paroi concave qui fait face au hublot H. La paroi concave de la bride B constitue la partie haute de la chambre de réflexion E. Cette paroi concave présente une forme de dôme circulaire dont l'axe méridien vertical passe par l'axe de l'âme R du connecteur C. La variation de hauteur entre la paroi concave de la bride B et l'antenne A permet d'optimiser la détection des décharges partielles sur la bande de fréquence de détection. Cette variation de hauteur permet en effet d'éviter les phénomènes de résonance susceptibles d'apparaître dans le spectre de détection contribuant ainsi à une homogénéisation de la sensibilité de détection sur tout le spectre utile. Le fait d'améliorer la sensibilité de détection grace à la chambre de réflexion permet avantageusement de limiter le nombre de capteurs et, en conséquence, le coût du dispositif de détection de décharge partielle.

De façon très avantageuse, quel que soit le type d'antenne, la Demanderesse constate qu'il est également possible, avec cette variante de l'invention, d'être conforme à la recommandation de sensibilité TGN21 intitulée « *Capacitive couplers for UHF partial discharge monitoring* » spécifiée dans la note technique *« Technical Guidance Note TGN(T) 121 »* de la National Grid Company plc.

Comme cela a été mentionné précédemment, la fixation de l'antenne A est préférentiellement effectuée à l'aide d'une mousse M, par exemple, un éthylène-propylène-diène monomère.

En conséquence, la Demanderesse propose également un dispositif de détection de décharge partielle de matériel haute tension isolé au gaz, caractérisé en ce qu'il comprend au moins une antenne placée à l'extérieur du matériel haute tension isolé au gaz, en vis-à-vis d'un hublot du matériel haute tension isolé au gaz, dans lequel une structure métallique qui entoure l'antenne contribue à former une cage de Faraday qui isole électriquement l'antenne de l'extérieur du matériel haute tension isolé au gaz, la cage de Faraday formant une enceinte de réflexion qui optimise la détection d'ondes par l'antenne. L'antenne est une antenne quelconque telle que mentionnée précédemment.

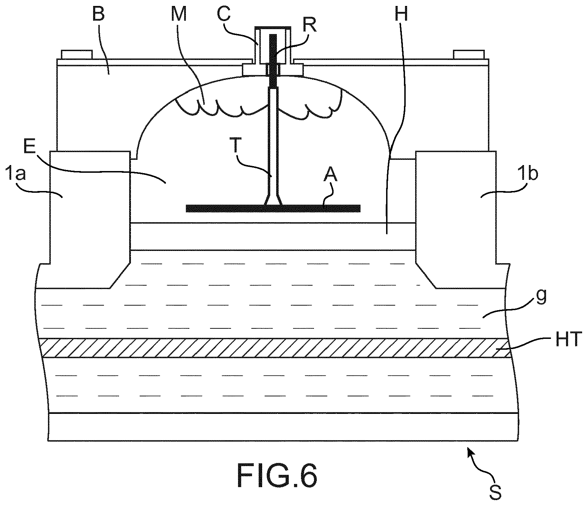

La figure 6 représente une première variante de dispositif de détection apte à optimiser le perfectionnement représenté en figure 5. Selon cette première variante, la paroi concave qui constitue la partie haute de la chambre de réflexion E ne présente pas la forme d'un dôme circulaire dont l'axe méridien vertical passe par l'axe de l'âme R du connecteur C.

La paroi concave présente une forme optimisée par calcul qui est également apte à homogénéiser la sensibilité de détection des décharges partielles sur le spectre de fréquences. Différentes formes de concavité peuvent être envisagées. Sur l'exemple de la figure 6, la concavité présente une disymétrie par rapport à l'axe de l'âme R du connecteur C.

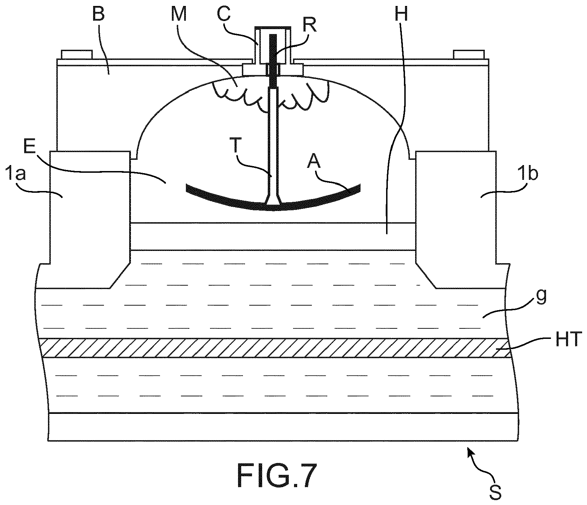

La figure 7 représente une deuxième variante de dispositif de détection apte à optimiser le perfectionnement représenté en figure 5. Selon cette deuxième variante, l'antenne A présente une face de forme concave en regard de la paroi de forme concave de la bride B. Différentes formes de concavité de l'antenne A peuvent être envisagées dans le cadre de l'invention. La variation de distance entre la paroi concave de la bride B et la face concave de l'antenne A permet d'optimiser l'homogénéisation de la sensibilité de détection des décharges partielles sur le spectre de fréquences. La concavité de la paroi supérieure de la bride B peut être conforme, par exemple, à celle représentée en figure 5 ou en figure 6.

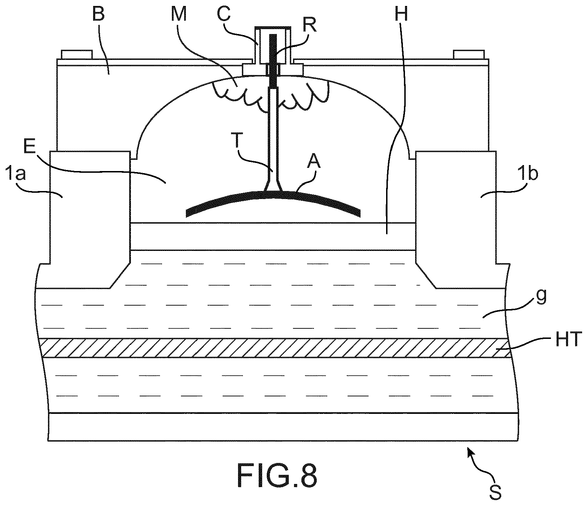

La figure 8 représente une troisième variante de dispositif de détection apte à optimiser le perfectionnement représenté en figure 5. Selon cette troisième variante, l'antenne A présente une face de forme convexe en regard de la paroi de forme concave de la bride B. La variation de distance entre la paroi concave de la bride B et la face convexe de l'antenne A permet également d'optimiser l'homogénéisation de la sensibilité de détection des décharges partielles sur le spectre de fréquences. La concavité de la paroi supérieure de la bride B peut être conforme, par exemple, à celle représentée en figure 5 ou en figure 6.

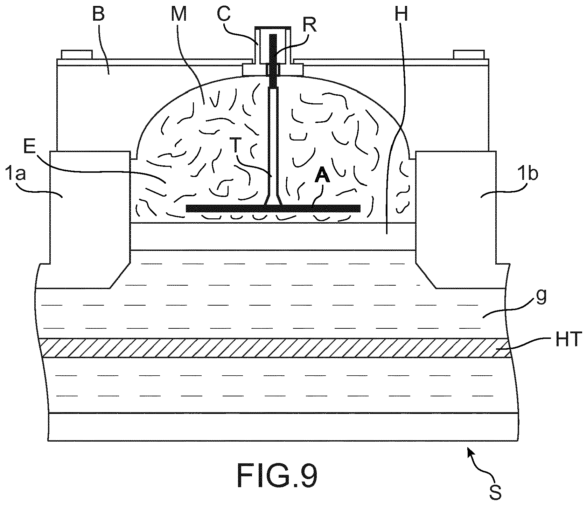

La figure 9 représente un dispositif de détection de décharge partielle de l'invention muni d'une première variante de moyens élastiques de maintien de l'antenne qui participe au dispositif de détection de l'invention.

La mousse M qui permet la fixation de l'antenne A est ici présente dans tout le volume de la chambre de réflexion E. De façon avantageuse, la mousse constitue un moyen élastique apte à combler les écarts de côtes lors de l'implantation de l'antenne sur le hublot.

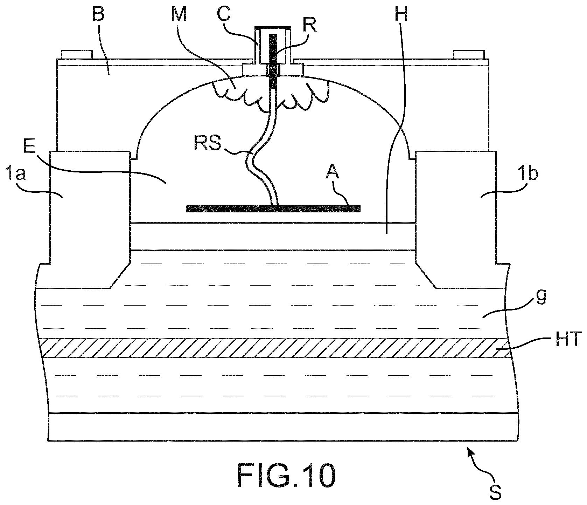

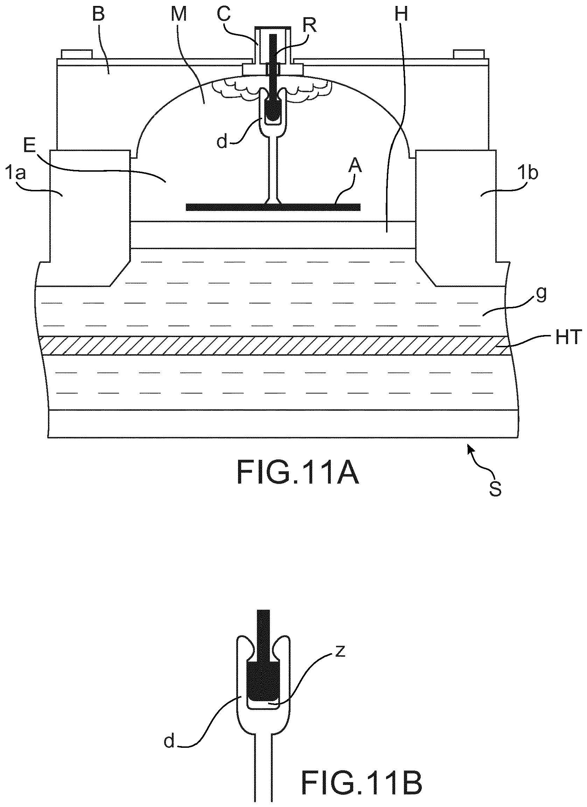

Les figures 10 et 11A-11B illustrent deux autres variantes de moyens élastiques de maintien de l'antenne. Selon ces deux autres variantes, la transition électrique T présente des propriétés élastiques.

Sur la figure 10, la transition électrique est un ressort électriquement conducteur RS qui est soudé, à une première de ses extrémités, à l'âme R du connecteur C et, à sa deuxième extrémité, à l'antenne A. Selon cette variante de l'invention, la mousse M qui fixe l'antenne A à la bride B peut emplir ou non le volume entier de la chambre E.

Sur les figures 11A et 11B, la transition électrique T est une connexion à coulissage. La connexion à coulissage comprend une douille d dans laquelle l'extrémité de l'âme R du connecteur est enfichée. En position de repos, un espace vide Z existe entre l'extrémité de l'âme R et le fond de la partie creuse de la douille d, permettant à l'âme R de coulisser dans la partie creuse de la douille. De façon avantageuse, ce système à coulissage constitue un moyen élastique apte exercer une force de rappel par rapport à une position initiale de l'antenne.

## Revendications

1. Dispositif de détection de décharge partielle de matériel haute tension isolé au gaz, le dispositif comprenant au moins une antenne (A) placée à l'extérieur du matériel haute tension isolé au gaz, en vis-à-vis d'un hublot (H) du matériel haute tension isolé au gaz, **caractérisé en ce qu'**il comprend, en outre, une bride métallique (B) qui est mise en contact électrique avec une paroi métallique (1a, 1b) du matériel haute tension et contribue à former, en combinaison avec la dite paroi, une cage de Faraday qui isole électriquement l'antenne de l'extérieur du matériel haute tension, la bride métallique (B) ayant une paroi concave qui fait face au hublot (H).

2. Dispositif selon la revendication 1, dans lequel un connecteur électrique (C) relié à l'antenne est fixé dans la bride (B).

3. Dispositif selon la revendication 2, dans lequel une transition électrique (T) relie une âme (R) du connecteur électrique (C) à l'antenne, la transition élecctrique pouvant avantageusement être :
- un fil électriquement conducteur ou un élément électriquement conducteur de géométrie fractale, le fil électriquement conducteur étant préférentiellement un ressort électriquement conducteur (RS), ou
- comprendre une connexion à coulissage (d) .

4. Dispositif selon l'une quelconque des revendications 1 à 3, dans lequel une mousse (M) emplit la cage de Faraday.

5. Dispositif selon l'une quelconque des revendications 1 à 4, dans lequel l'antenne (A) est une antenne monopolaire, ou une antenne dipolaire, ou une antenne à spirale, ou une antenne fractale.

6. Dispositif selon la revendication 5, dans lequel l'antenne présente :
- soit une surface concave qui fait face à la paroi concave de la bride,
- soit une surface convexe qui fait face à la paroi concave de la bride.

7. Dispositif de détection de décharge partielle de matériel haute tension isolé au gaz (S), le dispositif comprenant une antenne à architecture fractale (A) placée à l'extérieur dudit matériel, **caractérisé en ce que** l'antenne à architecture fractale (A) est située en vis-à-vis d'une face externe d'une pièce électriquement isolante qui assure le maintien d'une barre haute tension à l'intérieur du matériel haute tension, et dans lequel, en outre, une structure métallique (2a, 2b, B) qui entoure l'antenne (A) contribue à former une cage de Faraday qui isole électriquement l'antenne de l'extérieur du matériel haute tension isolé au gaz,
dans lequel la cage de Faraday forme une enceinte de réflexion (E) qui présente une paroi concave située face à la pièce électriquement isolante.

8. Dispositif selon la revendication 7, dans lequel la structure métallique comprend une bride (B) dans laquelle est fixé un connecteur électrique (C) qui est relié à l'antenne.

9. Dispositif selon la revendication 8, dans lequel une transition électrique (T) relie une âme du connecteur électrique (C) à l'antenne,
et dans laquelle la transition électrique peut avantageusement :
- être un fil électriquement conducteur ou un élément électriquement conducteur de géométrie fractale, le fil électriquement conducteur étant préférentiellement un ressort électriquement conducteur (RS), ou
- comprendre une connexion à coulissage (d) .

10. Dispositif selon l'une quelconque des revendications 7 à 9, dans lequel une mousse (M) emplit la totalité de l'enceinte de réflexion (E).

11. Dispositif selon l'une quelconque des revendications précédentes, dans lequel l'antenne comprend au moins une antenne 2D et/ou au moins une antenne 3D.

12. Poste électrique haute tension isolé au gaz équipé d'un dispositif de détection de décharge partielle, **caractérisé en ce que** le dispositif de détection de décharge partielle est un dispositif selon l'une quelconque des revendications 1 à 11.

## Patentansprüche

1. Vorrichtung zum Erfassen der Teilentladung einer gasisolierten Hochspannungsanlage, wobei die Vorrichtung mindestens eine Antenne (A) umfasst, die sich außerhalb der gasisolierten Hochspannungsanlage gegenüber einem Fenster (H) der gasisolierten Hochspannungsanlage befindet, **dadurch gekennzeichnet, dass** sie ferner einen Metallflansch (B) umfasst, der mit einer Metallwand (1a, 1b) der Hochspannungsanlage in elektrischem Kontakt steht und dazu beiträgt, in Kombination mit dieser Wand einen Faradayschen Käfig zu bilden, der die Antenne von der Außenseite der Hochspannungsanlage elektrisch isoliert, wobei der Metallflansch (B) eine konkave Wand aufweist, die dem Fenster (H) zugewandt ist.

2. Vorrichtung nach Anspruch 1, wobei ein mit der Antenne verbundener elektrischer Verbinder (C) im Flansch (B) befestigt ist.

3. Vorrichtung nach Anspruch 2, in der ein elektrischer Übergang (T) einen Kern (R) des elektrischen Verbinders (C) mit der Antenne verbindet, wobei der elektrische Übergang vorteilhafterweise:
- ein elektrisch leitender Draht oder ein elektrisch leitendes Element mit fraktaler Geometrie ist, wobei der elektrisch leitende Draht vorzugsweise eine elektrisch leitende Feder (RS) ist, oder
- eine Gleitverbindung (d) umfasst.

4. Vorrichtung nach einem der Ansprüche 1 bis 3, wobei ein Schaum (M) den Faradayschen Käfig ausfüllt.

5. Vorrichtung nach einem der Ansprüche 1 bis 4, wobei es sich bei der Antenne (A) um eine Monopolantenne oder eine Dipolantenne, eine Spiralantenne oder eine fraktale Antenne handelt.

6. Vorrichtung nach Anspruch 5, wobei die Antenne aufweist:
- entweder eine konkave Oberfläche, die der konkaven Wand des Flansches zugewandt ist,
- oder eine konvexe Oberfläche, die der konkaven Wand des Flansches zugewandt ist.

7. Vorrichtung zum Erfassen einer Teilentladung einer gasisolierten Hochspannungsanlage (S), wobei die Vorrichtung eine Antenne (A) mit fraktaler Architektur umfasst, die sich außerhalb der Anlage befindet, **dadurch gekennzeichnet, dass** die Antenne (A) mit fraktaler Architektur gegenüber einer Außenfläche eines elektrisch isolierenden Teils angeordnet ist, womit sichergestellt wird, dass ein Hochspannungsstab innerhalb der Hochspannungsanlage gehalten wird, und wobei zusätzlich eine Metallstruktur (2a, 2b, B), die die Antenne (A) umgibt, zur Bildung eines Faradayschen Käfigs beiträgt, der die Antenne von der Außenseite der gasisolierten Hochspannungsanlage elektrisch isoliert,
wobei der Faradaysche Käfig eine Reflexionskammer (E) bildet, die eine konkave Wand aufweist, die dem elektrisch isolierenden Teil zugewandt ist.

8. Vorrichtung nach Anspruch 7, wobei die Metallstruktur einen Flansch (B) umfasst, in dem ein elektrischer Verbinder (C) befestigt ist, der mit der Antenne verbunden ist.

9. Vorrichtung nach Anspruch 8, wobei ein elektrischer Übergang (T) einen Kern des elektrischen Verbinders (C) mit der Antenne verbindet,
und wobei der elektrische Übergang vorteilhafterweise:
- ein elektrisch leitender Draht oder ein elektrisch leitendes Element mit fraktaler Geometrie sein kann, wobei der elektrisch leitende Draht vorzugsweise eine elektrisch leitende Feder (RS) ist, oder
- eine Gleitverbindung (d) umfassen kann.

10. Vorrichtung nach einem der Ansprüche 7 bis 9, wobei ein Schaum (M) die gesamte Reflexionskammer (E) ausfüllt.

11. Vorrichtung nach einem der vorhergehenden Ansprüche, wobei die Antenne mindestens eine 2D-Antenne und / oder mindestens eine 3D-Antenne umfasst.

12. Gasisolierte elektrische Hochspannungsstation, die mit einer Vorrichtung zum Erfassen der Teilentladung ausgestattet ist, **dadurch gekennzeichnet, dass** es sich bei der Vorrichtung um eine Vorrichtung nach einem der Ansprüche 1 bis 11 handelt.

## Claims

1. Device for detecting a partial discharge from high-voltage gas-insulated equipment, the device comprising at least one antenna (A) arranged outside the high-voltage gas-insulated equipment, opposite a hatch (H) of the high-voltage gas-insulated equipment, **characterised in that** it further comprises a metal flange (B) placed in electrical contact with a metal wall (1a, 1b) of the high-voltage equipment and contributes to forming, together with said wall, a Faraday cage that electrically insulates the antenna from the outside of the high-voltage equipment, the metal flange (B) having a concave wall opposite the hatch (H).

2. Device according to claim 1, wherein an electric connector (C) connected to the antenna is secured inside the flange (B).

3. Device according to claim 2, wherein an electric transition (T) connects a core (R) of the electric connector (C) to the antenna, the electric transition advantageously:
- being an electrically conducting wire or an electrically conducting element featuring fractal geometry, the electrically conducting wire being preferably an electrically conducting spring (RS), or
- comprising a sliding connection (d).

4. Device according to any one of the claims 1 to 3, wherein a foam (M) fills the Faraday cage.

5. Device according to any one of the claims 1 to 4, wherein the antenna (A) is a monopole antenna, or a dipole antenna, or a spiral antenna, or a fractal antenna.

6. Device according to claim 5, wherein the antenna has:
- either a concave surface that faces the concave wall of the flange,
- or a convex surface that faces the concave wall of the flange.

7. Device for detecting a partial discharge from high-voltage gas-insulated equipment (S), the device comprising an antenna (A) featuring fractal architecture placed outside said equipment, **characterised in that** the antenna (A) featuring fractal architecture is located opposite an external face of an electrically insulating part that ensures that a high-voltage bar is maintained inside the high-voltage equipment, and wherein a metal structure (2a, 2b, B) surrounding the antenna (A) further contributes to forming a Faraday cage that electrically insulates the antenna from the outside of the high-voltage gas-insulated equipment,
wherein the Faraday cage forms a reflection enclosure (E) that comprises a concave wall opposite the electrically insulating part.

8. Device according to claim 7, wherein the metal structure comprises a flange (B) wherein is secured an electric connector (C) connected to the antenna.

9. Device according to claim 8, wherein an electric transition (T) connects a core of the electric connector (C) to the antenna,
and wherein the electric transition can advantageously:
- be an electrically conducting wire or an electrically conducting element featuring fractal geometry, the electrically conducting wire being preferably an electrically conducting spring (RS), or
- comprise a sliding connection (d).

10. Device according to any one of the claims 7 to 9, wherein a foam (M) fills the entire reflection enclosure (E).

11. Device according to any one of the preceding claims, wherein the antenna comprises at least one 2D antenna and/or at least one 3D antenna.

12. High-voltage gas-insulated electrical station equipped with a device for detecting a partial discharge, **characterised in that** the partial discharge detection device is a device according to any one of the claims 1 to 11.
